# DEMANDE DE BREVET EUROPEEN

(11) **EP 4 365 957 A1**
(43) Date de publication de la demande: **08.05.2024**
(21) Numéro de dépôt: 22205388.6
(22) Date de dépôt: 03.11.2022
(51) Int. Cl.: H01L 31/02, G05F 1/67, H01L 31/0465, H01L 31/05, H02S 40/32, H02S 40/34

(54) **ENSEMBLE A CELLULES PHOTOVOLTAIQUES ET MODULE A CELLULES ET A CIRCUIT ELECTRONIQUE AYANT UNE ZONE DE MESURE**

(71) Demandeur: ETA SA Manufacture Horlogère Suisse, 2540 Grenchen (CH)
(72) Inventeur: KLOPFENSTEIN, François, 2800 Delémont (CH); BAILAT, Julien, 2503 Bienne (CH)
(74) Mandataire: ICB SA

(57) **Abrégé**

La présente invention concerne un ensemble (10) à cellules photovoltaïques (2, 12). L'ensemble (10) comprend au moins une couche conductrice (21, 23; 25, 25') sur une face de dessus du substrat (22; 28) ou une face de dessous du substrat (22; 28) pour établir un contact électrique des cellules photovoltaïques (2, 12). Il est prévu au moins une première cellule photovoltaïque (2) de grande taille pour capter de l'énergie lumineuse à convertir en énergie électrique dans un module (1). Au moins une seconde cellule photovoltaïque (12) est prévue de petite taille et indépendante de la première cellule photovoltaïque (2). Elle est agencée pour mesurer dans le module (1) une tension ou un courant pour optimiser le fonctionnement du module (1).

## Description

### Domaine technique de l'invention

L'invention se rapporte à un ensemble à cellules photovoltaïques et également à un module à cellules photovoltaïques et à circuit électronique ayant au moins une zone de mesure d'au moins une tension ou d'un courant.

### Arrière-plan technologique

Des convertisseurs chargés de récolter l'énergie d'une cellule photovoltaïque sont bien connus. Ils doivent de préférence intégrer un mécanisme de poursuite du point de puissance maximale, qui est défini sous la terminologie MPPT (*"maximum power point tracking"* en anglais). Cette puissance maximale Pmpp correspond à un point de fonctionnement MPP, qui est caractérisé par une tension Vmpp et un courant Impp bien précis, par ailleurs dépendant du niveau d'éclairement.

Différentes techniques sont connues, notamment on peut citer la méthode dite *"perturb and observe"* qui consiste à perturber périodiquement la tension de fonctionnement et observer la variation de puissance résultante comme décrit dans la demande de brevet WO 2013/105008 A2. En fonction du signe de cette variation, la perturbation de tension sera conservée ou au contraire inversée. Cette méthode est généralement très efficace, mais peut tout de même présenter quelques inconvénients. Les inconvénients sont notamment un risque d'oscillation, ainsi qu'une relative complexité de l'électronique. Cela peut pénaliser la consommation électrique du système de régulation de manière significative dans les systèmes à faible puissance et dans les applications horlogères.

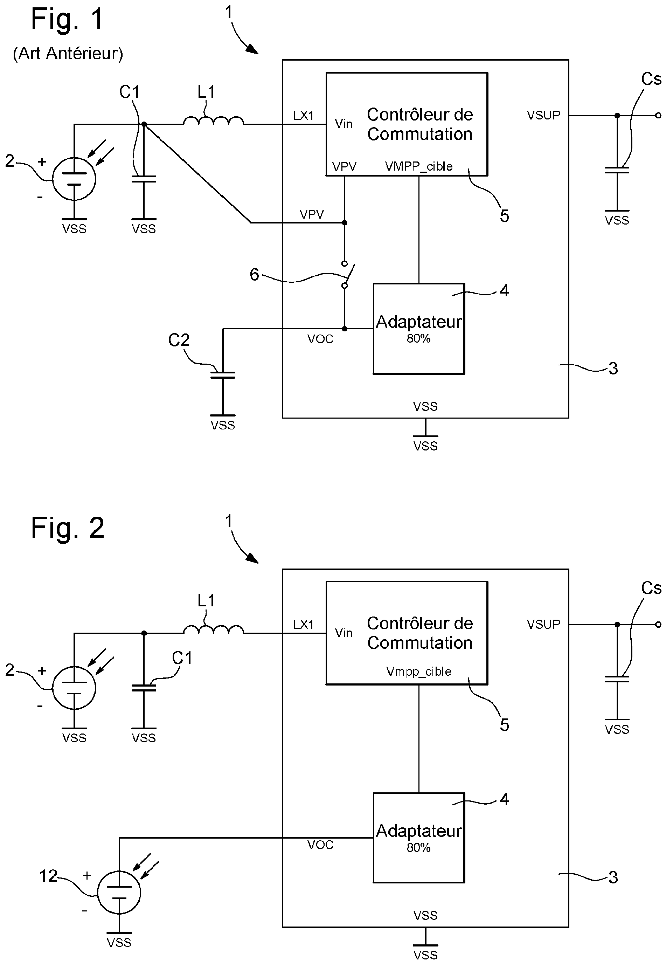

Une autre méthode bien connue est la méthode dite "tension à vide" (*"open voltage"* en anglais) comme on peut le voir en référence à la figure 1 du module 1 cellule photovoltaïque 2 à circuit électronique 3. Cette méthode consiste à mesurer périodiquement la tension à vide Voc (*"open circuit*") de la cellule solaire 2 et adapter en conséquence la tension de fonctionnement, souhaitée proche de Vmpp. Une variante simple consiste à multiplier la tension à vide par un facteur constant, par exemple 80%, et ajuster ensuite en conséquence la tension de fonctionnement. Cette méthode est aisée à implémenter dans un circuit électronique, mais elle n'est pas idéale dans toutes les conditions d'éclairement, car le rapport Vmpp / Voc n'est pas parfaitement constant selon l'éclairement. Une variante plus complexe consiste à adapter le facteur en fonction de la tension à vide. Il faut au préalable déterminer la fonction de la tension Vmpp = f(Voc), de sorte à pouvoir par la suite approximer cette fonction par la régulation électronique, par exemple en exploitant une table de valeurs (*look-up table*).

Un inconvénient de la méthode *"open voltage*" est qu'il faut interrompre la collecte d'énergie pendant une courte période de mesure de la tension à vide Voc. La durée de cette mesure dépend en pratique du temps qu'il faut à la cellule solaire pour charger à Voc les inévitables condensateurs électriques, intrinsèques ou externes, qu'elle voit à ses bornes. De plus, la périodicité de la mesure Voc doit être adaptée à la variabilité de l'éclairement. S'agissant d'une application horlogère, on peut prendre l'exemple d'un porteur de montre solaire se déplaçant en forêt: à chaque pas, à chaque mouvement du bras, la lumière reçue peut varier significativement, et la tension de fonctionnement devrait idéalement être adaptée instantanément ou fréquemment, par exemple à chaque seconde. En pratique, il est inefficace d'interrompre la collecte d'énergie à une fréquence si élevée pour mesurer la tension Voc.

La figure 1 représente un module 1 à cellule solaire 2 et à circuit électronique 3 de l'art antérieur, utilisant la méthode de mesure de la tension à vide comme expliqué en partie ci-dessus. Le module 1 à cellule solaire 2 de l'art antérieur comprend la cellule électronique 3 avec des composants connectés d'un côté extérieur du circuit électronique 3. La cellule solaire ou photovoltaïque 2 peut prendre la forme d'un cadran ou d'une lunette ou d'une glace d'une montre, ou d'une autre partie d'une montre.

D'un premier côté du module 1, la cellule solaire 2 est prévue pour capter de la lumière et convertir cette lumière en énergie électrique telle qu'une tension chargée sur un premier condensateur C1. La tension VPV chargée sur le condensateur C1 est fournie à un contrôleur de commutation 5 dans le circuit électronique 3. Une inductance L1 est également prévue en liaison du premier condensateur C1 et d'une entrée Vin du contrôleur de commutation 5, ce qui est bien connu pour des circuits convertisseur DC-DC de type « step-up ».

Une temporisation de commutation est opérée dans le contrôleur de commutation 5 de manière à fermer par périodes de temps déterminées un commutateur 6 disposé entre le premier condensateur C1 et un second condensateur C2 pour la mesure de la tension à vide Voc. Cette tension à vide Voc est fournie à un adaptateur 4, qui permet d'adapter la tension à transmettre au collecteur de commutation 5 à une valeur correspondant par exemple à 80% de la valeur maximale moyenne provenant de l'adaptateur 4 et adapter en conséquence la tension de fonctionnement, souhaitée proche de Vmpp. Ainsi la tension de fonctionnement souhaitée est fournie en sortie Vsup et est chargée sur un condensateur de sortie Cs.

### Résumé de l'invention

La présente invention propose donc un ensemble à cellules photovoltaïques destiné à faire partie d'un module à cellules photovoltaïques et à circuit électronique permettant d'effectuer une mesure fréquente ou même permanente d'une tension d'une cellule photovoltaïque, ou d'un courant de cette cellule photovoltaïque. Ceci permet de pouvoir adapter rapidement le point de fonctionnement du circuit électronique ou du module complètement et en palliant les inconvénients cités de l'art antérieur. L'invention permet de faciliter la mesure d'une tension même à une fréquence élevée et palliant les inconvénients de l'art antérieur cité ci-dessus.

Cet avantage est d'autant plus important que les conditions d'éclairement changent rapidement et fréquemment, ce qui est typiquement le cas d'une montre portée par un utilisateur actif. La combinaison dans un ensemble à cellules photovoltaïques d'une portion ou zone pour la mesure d'une tension par exemple d'une tension à vide et d'une portion ou zone de captation d'énergie lumineuse permet d'effectuer une mesure de la tension à tout moment indépendamment de la fréquence de fonctionnement du circuit électronique du module à cellules photovoltaïques et à circuit électronique.

A cet effet, la présente invention concerne un ensemble à cellules photovoltaïques défini dans la revendication indépendante 1.

Des formes particulières de réalisation de l'ensemble à cellules photovoltaïques sont définies dans des revendications dépendantes 2 à 20.

A cet effet la présente invention concerne également un module à cellules photovoltaïques et à circuit électronique ayant une zone de mesure d'une tension ou d'un courant selon la revendication indépendante 21.

Des formes particulières de réalisation du module sont définies dans les revendications dépendantes 22 et 23.

Un avantage de l'ensemble à cellules photovoltaïques pour ledit module à cellules photovoltaïques et à circuit électronique réside dans le fait que selon une première variante de réalisation, l'ensemble à cellules photovoltaïques comprend une première ou plusieurs premières cellules photovoltaïques ou solaires de grande taille destinées à capter l'énergie lumineuse pour la convertir en énergie électrique, et une seconde cellule photovoltaïque ou solaire indépendante et de taille réduite destinée à mesurer une tension ou un courant dans le circuit électronique du module. Il peut s'agir d'une mesure d'une tension à vide par exemple en continu ou d'un courant court-circuit.

La ou les premières cellules photovoltaïques peuvent être des cellules à couches minces.

Avantageusement, la portion ou zone de captation d'énergie lumineuse destinée à la mesure d'une tension ou d'un courant peut occuper une surface représentant par exemple le 1 % de la surface totale de l'ensemble des cellules photovoltaïques. Par contre, avec le fonctionnement par exemple en continu de la mesure de cette tension, par exemple de la tension à vide, dans le circuit électronique du module ou de ce courant court-circuit, cela permet de gagner pratiquement au minimum 10 % de plus de captation d'énergie électrique, ce qui est un avantage considérable par rapport à l'art antérieur.

Une première cellule photovoltaïque de l'ensemble est de grande taille pour capter l'énergie lumineuse. La seconde cellule photovoltaïque de l'ensemble est de petite taille et est destinée à servir principalement pour la mesure d'une tension ou d'un courant, par exemple de la tension à vide Voc ou du courant court-circuit dans le circuit électronique du module. Bien entendu, il est supposé que les deux types de cellules photovoltaïques ont une tension à vide Voc très semblable en fonction de l'éclairement. Dans une application horlogère de la présente invention, la ou les premières cellules solaires peuvent être intégrées au cadran d'une montre ou prendre la forme directement du cadran de montre, ou être liées au verre de montre. Le fait d'avoir deux types de cellules différentes peut éventuellement présenter un inconvénient esthétique, étant donné que les bords desdites cellules peuvent être visibles. De plus, la séparation physique des deux cellules par une zone isolante tend à diminuer la surface active disponible pour la collecte d'énergie. Cependant que l'ensemble à cellules photovoltaïques destinées à un module à cellules photovoltaïques et à circuit électronique soit lié au cadran ou au verre de montre, les parties de l'ensemble de cellules photovoltaïques, susceptibles d'être visibles peuvent être réalisées d'une même couleur que la première cellule et/ou la seconde cellule de manière à ne pas les distinguer à travers le verre de montre. Un autre léger inconvénient est qu'en prévoyant une zone isolante entre les deux portions cela réduit de manière minimale la surface de la première cellule, qui est destinée à capter de l'énergie lumineuse à convertir en énergie électrique.

Un autre avantage de l'ensemble à cellules photovoltaïques destiné à faire partie du module à cellules photovoltaïques et à circuit électronique réside dans le fait que selon une seconde variante de réalisation, l'ensemble à cellules photovoltaïques pour ledit module comprend des caractéristiques particulières de cellules silicium de type IBC (acronyme de *"interdigitated back contact*" en terminologie anglaise). C'est l'idée de mettre en œuvre une cellule essentiellement mono-segment pour ce qui est du substrat monocristallin et de la couche amorphe frontale, et d'isoler seulement la structure arrière, diffusion et métallisation. Autrement dit, il s'agit d'affecter une petite zone de la cellule IBC à la mesure d'une tension, par exemple de la tension à vide Voc, au moyen de deux doigts ou peignes p et n électriquement indépendants à l'arrière de la cellule. On assume que cette zone de mesure est significativement plus petite que la zone principale consacrée à la collecte d'énergie.

### Brève description des figures

Les buts, avantages et caractéristiques d'un ensemble à cellules photovoltaïques destiné à faire partie d'un module à cellules photovoltaïques et à circuit électronique ayant au moins une zone de mesure d'une tension ou d'un courant apparaîtront mieux dans la description suivante de manière non limitative en regard des dessins sur lesquels :
- la figure 1 représente un module cellule photovoltaïque de l'art antérieur, qui est muni d'un circuit électronique de traitement des données et adapté pour une mesure de la tension à vide,
- la figure 2 représente un module à cellules photovoltaïques selon l'invention, qui est muni d'un circuit électronique de traitement des données,
- la figure 3 représente une forme d'exécution des différentes couches d'un ensemble à cellules photovoltaïques destiné à faire partie d'un module à cellules photovoltaïques et à cellule électronique d'une première variante de réalisation selon la présente invention,

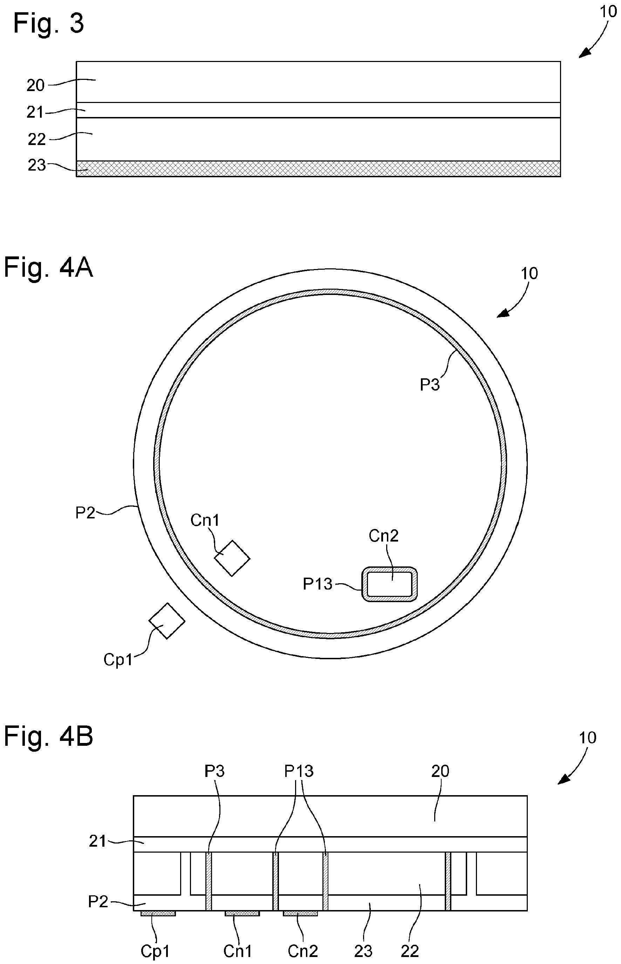

- les figures 4A et 4B représentent d'une part à la figure 4A une vue de dessus du support sous forme de plaquette de l'ensemble à cellules photovoltaïques pour un module à cellules photovoltaïques et à circuit électronique selon une première variante de réalisation de la présente invention, et d'autre part à la figure 4B une vue en coupe transversale de l'ensemble à cellules photovoltaïques sous forme de plaquette pour visionner les différents contacts pour la mesure d'une tension, par exemple de la tension à vide dans le circuit électronique du module et de la captation d'énergie électrique par des signaux lumineux selon la présente invention, et
- les figures 5A et 5B représentent d'une part à la figure 5A une vue de dessus du support sous forme de plaquette de l'ensemble à cellules photovoltaïques pour un module à cellules photovoltaïques et à circuit électronique selon une seconde variante de réalisation de la présente invention, et d'autre part à la figure 5B une vue en coupe transversale de l'ensemble à cellules photovoltaïques sous forme de plaquette pour visionner au moins deux dents de chaque peigne en alternance sur une couche cristalline de silicium par exemple selon la présente invention.

### Description détaillée de l'invention

Dans la description suivante, il est décrit tous les composants d'un ensemble à cellules photovoltaïques destiné à faire partie d'un module à cellules photovoltaïques et à circuit électronique. Tous les composants de base de mesure bien connus dans le domaine technique ne seront décrits que sommairement. Il sera décrit principalement la structure de l'ensemble à cellules photovoltaïques pour un module à cellules photovoltaïques et à circuit électronique et sa conception.

Comme expliqué ci-après notamment en figure 2 dans une première variante de réalisation, l'ensemble 10 à cellules photovoltaïques 2 et 12 peut être placé sur un support, tel que sur une plaque de verre qui peut constituer le verre d'une montre portée au poignet principalement. Les deux cellules photovoltaïques 2 et 12 sont capables de capter de l'énergie lumineuse afin de la convertir en énergie électrique, mais la seconde cellule 12 plus petite est utilisée pour la mesure d'une tension, par exemple de la tension à vide, voire également pour la mesure d'un courant, par exemple d'un courant court-circuit. Un usinage laser peut être effectué à travers le verre comme c'est un isolant et qu'il est transparent également. Pour la cellule de la mesure de la tension à vide, la puissance en sortie de mesure est égale à zéro d'où le terme spécifique de tension à vide.

La figure 2 représente le module 1 à cellules photovoltaïques 2, 12 et à circuit électronique 3. Quelques composants électroniques relient encore la base du circuit électronique 3 et la ou les cellules photovoltaïques 2, 12 de la présente invention. Ledit module 1 comprend aussi bien une ou plusieurs cellules photovoltaïques ou solaires 2, 12 reliées à un circuit électronique 3, que les différents composants électroniques reliant la ou les cellules photovoltaïques et la base du circuit électronique 3. Il peut être envisagé d'avoir une première cellule ou plusieurs premières cellules photovoltaïques 2 connectées l'une à l'autre pour former par exemple un cadran de montre ou pour être disposées sur un support, tel qu'un verre de montre et au moins une seconde cellule photovoltaïque 12 de mesure de la tension à vide qui est en définitive une petite cellule photovoltaïque ou solaire. Cette seconde cellule solaire est agencée pour pouvoir effectuer de manière indépendante une mesure de la tension à vide Voc, mais peut également être agencée pour mesurer un courant court-circuit dans le module 1. Cette petite cellule photovoltaïque peut être connectée à tout moment et notamment en continu depuis le début de la mesure de la tension à vide sans être déconnectée. Grâce à cette petite cellule photovoltaïque 12, il est ainsi possible de fournir une information pour adapter le point de fonctionnement du circuit électronique 3 ou complètement du module 1 la comprenant.

Comme représenté à la figure 2, le module 1 comprend au moins une première cellule photovoltaïque ou solaire 2 pour capter l'énergie lumineuse et la convertir en énergie électrique, qui est chargée côté positif sur un condensateur C1 d'entrée relié également à la masse Vss côté négatif. Le module 1 comprend encore une inductance L1 reliant le côté positif du condensateur C1 d'entrée à une borne de tension d'entrée Vin du contrôleur de commutation 5 dans le circuit électronique 3, ce qui est bien connu pour des circuits convertisseur DC-DC de type « step-up ». Ce contrôleur de commutation 5 peut être cadencé par une base de temps ou par un oscillateur local composé en partie par l'inductance L1 de liaison LX1. Cependant la base de temps ou l'oscillateur de cadencement peut aussi être entièrement intégré dans le contrôleur de commutation 5 ou le circuit électronique 3 pour cadencer toutes les opérations notamment du contrôleur de commutation 5.

Le circuit électronique 3 comprend également un adaptateur 4 qui est relié au contrôleur de commutation 5 et directement à la seconde cellule photovoltaïque ou solaire 12. Il peut y avoir une communication de paramètres de configuration entre le contrôleur de commutation 5 et l'adaptateur 4 concernant un niveau de tension déterminé c'est-à-dire une valeur cible Vmpp_cible à prévoir pour le bon fonctionnement du module. L'adaptateur 4 reçoit à tout moment et notamment en continu un signal de mesure d'une tension ou d'un courant, par exemple de la tension à vide Voc de la seconde cellule photovoltaïque ou solaire 12 ou d'un courant court-circuit. Au début de la mesure, il y a une croissance du courant à travers la diode de la seconde cellule photovoltaïque 12 jusqu'à arriver à un point de tension Vmpp, qui constitue la tension de fonctionnement idéale du circuit électronique 3. Cependant la courbe tension courant se termine avec une chute du courant jusqu'à arriver à une valeur de tension à vide Voc sur l'axe de tension où le courant devient nul. Il peut être déterminé par la fonction de la tension Vmpp = f(Voc), une tension de fonctionnement du circuit électronique proche de la valeur maximale ciblée Vmpp.

La seconde cellule photovoltaïque 12 peut donc être prévue pour mesurer à tout moment et notamment en continu une tension ou un courant, par exemple la tension à vide Voc, car cette seconde cellule photovoltaïque ou solaire 12 est indépendante de la ou des premières cellules photovoltaïques ou solaires 2, qui sont chargées de mesurer l'énergie lumineuse en la convertissant en énergie électrique.

Cette mesure de tension par exemple de la tension à vide Voc est fournie à un adaptateur 4, qui permet d'adapter la tension à transmettre au contrôleur de commutation 5 à une valeur correspondant par exemple à 80 % de la valeur maximale moyenne provenant de l'adaptateur 4 et adapter en conséquence la tension de fonctionnement, souhaitée proche de Vmpp qui peut être la valeur cible (Vmpp_cible) définie préalablement. Ainsi la tension de fonctionnement souhaitée est fournie en sortie Vsup du contrôleur de commutation 5 et est chargée côté positif sur un condensateur de sortie Cs, relié à la masse Vss côté négatif.

Il est à noter qu'il peut être prévu de connecter inversement le module 1 cellule photovoltaïque à circuit électronique 3 par rapport à une borne de tension positive plutôt que par rapport à la masse Vss comme décrit dans les figures 1 et 2 pour décrire le fonctionnement dudit module 1.

Pour réaliser le module 1 à cellules photovoltaïques 2, 12 et à circuit électronique 3 de la première variante de réalisation, on peut se reporter tout d'abord à la figure 3. Cette figure 3 représente différentes couches d'un ensemble 10 à cellules photovoltaïques destiné à faire partie d'un module 1 à cellules photovoltaïques et à cellule électronique d'une première variante de réalisation d'un ensemble de couches du module 1 avant la réalisation de la connexion des cellules photovoltaïques. L'ensemble 10 comprend une première couche conductrice, qui peut être une première couche conductrice transparente 21, destinée à venir fixer le substrat 22 sous une face d'un support de l'ensemble.

La première couche conductrice 21 peut être disposée sur une première face d'un substrat 22 en matériau de type amorphe, par exemple en matériau semi-conducteur tel qu'en silicium amorphe (a-Si). La première couche conductrice 21 peut être une couche d'oxyde conductrice transparente TCO, mais il peut être imaginé d'autres couches conductrices à utiliser. Une seconde couche métallique 23 peut être disposée sur une seconde face opposée à la première face du substrat 22 ou du support.

Le matériau du substrat 22 de la première cellule photovoltaïque 2 peut être donc un silicium amorphe.

La seconde couche conductrice 23 est reliée à la première couche conductrice 21 par une ouverture périphérique de l'ensemble 10 réalisée dans le substrat 22 ou dans la première cellule photovoltaïque 2.

Bien entendu, plusieurs autres couches peuvent être placées au-dessus ou au-dessous des couches décrites ci-dessus de l'ensemble.

L'ensemble 10 à cellules photovoltaïques est destiné à être fixé par sa première couche conductrice 21 sur une face inférieure d'un support 20 transparent, tel qu'un verre par exemple un verre de montre ou sur un autre type de support. L'épaisseur totale de l'ensemble 10 peut être inférieure à 500 µm et de préférence même inférieure à 100 µm.

Il est à noter que dans cette première variante de réalisation, le support transparent 20 ou le support d'un autre type peut faire partie de l'ensemble 10 après toutes les étapes de connexion des composants électroniques et des cellules photovoltaïques du module 1.

La première variante de réalisation de l'ensemble 10 à cellules photovoltaïques pour faire partie du module à cellules photovoltaïques et à circuit électronique est représentée aux figures 4A et 4B. La figure 4A représente une vue de dessus de l'ensemble 10 à cellules photovoltaïques, alors que la figure 4B représente une coupe verticale au niveau des contacts de connexion de l'ensemble 10 à cellules photovoltaïques.

Selon la première variante de réalisation, l'ensemble 10 à cellules photovoltaïques comprend deux cellules agencées indépendantes l'une de l'autre. Une première cellule photovoltaïque 2 de grande taille est agencée pour collecter l'énergie lumineuse, et la convertir en énergie électrique, alors qu'une seconde cellule photovoltaïque 12 de petite taille est agencée pour effectuer la mesure de la tension à vide Voc, voire du courant court-circuit.

La première cellule photovoltaïque 2 peut être une cellule à couches minces disposée sur un support d'un autre type de la forme d'un substrat.

Il est toutefois à noter que sur les figures 4A et 4B, il est plutôt représenté le substrat 22 sous forme de plaquette ou portion de plaquette sur laquelle sont réalisés les contacts électriques des cellules photovoltaïques et leur emplacement sur la plaquette. Lesdites cellules photovoltaïques ou solaires sont réalisées principalement dans une ou des plaquettes de substrat, qui sont des plaquettes de silicium ou sur un ou plusieurs supports d'un matériau en verre, ou en plastique, ou en métal avec une couche d'isolation, ou sur des couches cristallines.

La figure 4A représente une vue de dessus de la première variante de réalisation de l'ensemble 10 à cellules photovoltaïques destiné à faire partie du module à cellules photovoltaïques et à circuit électronique. La figure 4B représente par contre une vue en coupe transversale au niveau de la position des contacts électriques de l'ensemble 10 à capteurs photovoltaïques fixé sur le support 20, qui fait partie de l'ensemble 10. L'ensemble 10 avec sa première couche fixée sur la face inférieure du support 20, qui est de préférence du verre, il est possible d'effectuer des opérations d'usinage notamment par laser. Il peut être prévu d'effectuer un usinage ou gravure depuis le dessus du verre à travers le module, étant donné la transparence du verre et de certaines parties de l'ensemble comme la première couche d'oxyde conducteur transparent. Il s'agit d'une variante pour cellule à couches minces sur un support en verre par exemple.

Avec l'usinage laser bien connu, il est possible d'effectuer ladite gravure à travers le substrat 22 de silicium de type amorphe de manière à donner accès à la première couche 21 d'oxyde conducteur transparent pour polariser cette couche à un potentiel commun positif ou négatif de préférence dans ce cas de figure positif. Pour ce faire, la seconde couche métallique 23 (définie P2) sur la face opposée du substrat 22 peut connecter par exemple par un anneau métallique P2 la première couche 21 d'oxyde conducteur transparent. Un contact positif Cp1 disposé sur cette seconde couche métallique 23 en bordure ou périphérie permet de polariser toute la première couche 21 d'oxyde conducteur transparent à un même potentiel par exemple un potentiel positif pour les deux cellules photovoltaïques.

Par exemple au moyen d'usinage laser, il est également possible de réaliser une couche d'isolation P3 pour la grande cellule photovoltaïque et une autre couche d'isolation P13 pour la petite cellule photovoltaïque. Chaque couche d'isolation P3 et P13 s'étend de la seconde couche métallique 23 jusqu'au moins au contact de la première couche 21 d'oxyde conducteur transparent. Ainsi il est possible d'appliquer un contact négatif Cn1 sur la première grande cellule photovoltaïque sur le substrat par l'intermédiaire de la seconde couche métallique 23 isolée de la bordure P2. Et cela permet également d'isoler la petite cellule photovoltaïque par l'autre couche d'isolation P13 pour venir connecter par un autre contact négatif Cn2 sur la seconde petite cellule photovoltaïque sur le substrat par l'intermédiaire de la seconde couche métallique 23.

Bien entendu à titre de rappel sur le cas présenté ci-dessus, la plage commune d'alimentation correspond à une borne positive d'une source d'alimentation, qui provient principalement de la conversion de l'énergie lumineuse en énergie électrique par la première cellule photovoltaïque ou solaire. Cependant dans le cas présenté notamment à la figure 2, la plage commune est plutôt la borne de masse définie comme la borne côté négatif. Mais l'agencement de connexion des différentes plages de contact ne change pas.

Il est encore prévu une isolation P3 de la première grande cellule photovoltaïque ou solaire de forme circulaire dans ce cas de figure, mais non limité à cette forme présentée à la figure 4A. De plus, autour de cette isolation P3, il est prévu une ligne ou bande d'interconnexion P2 pour relier le contact complémentaire commun Cp1 de connexion positive au côté positif de la première cellule photovoltaïque ou solaire et de la seconde cellule photovoltaïque ou solaire.

Un contact positif Cp1 est disposé sur la seconde couche conductrice 23 en périphérie destiné à permettre de polariser la première couche conductrice 21 à un même potentiel positif pour les deux cellules photovoltaïques, en ce qu'un contact négatif Cn1 est disposé sur la grande cellule photovoltaïque 2 sur le substrat par l'intermédiaire de la seconde couche conductrice 23 isolée de la bordure P2, et en ce qu'un autre contact négatif Cn2 est disposé sur la petite cellule photovoltaïque 12 sur le substrat par l'intermédiaire de la seconde couche conductrice 23.

Même si la seconde ou petite cellule photovoltaïque 12 est généralement disposée dans la première ou grande cellule photovoltaïque 2, il est néanmoins concevable de la réaliser aussi d'un côté extérieur à l'isolation P3 et jusqu'à la bordure P2.

Il est à noter encore que l'ensemble 10 à cellules photovoltaïques monté dans le module à cellules photovoltaïques et à circuit électronique, il peut être envisagé d'inverser la polarité des différents contacts disposés sur chaque cellule photovoltaïque. A ce titre, le contact complémentaire Cp1 peut devenir un contact côté négatif, alors que le premier contact négatif Cn1 et l'autre contact négatif Cn2 peuvent devenir des contacts du côté positif, une fois que l'ensemble 10 est monté dans le module 1.

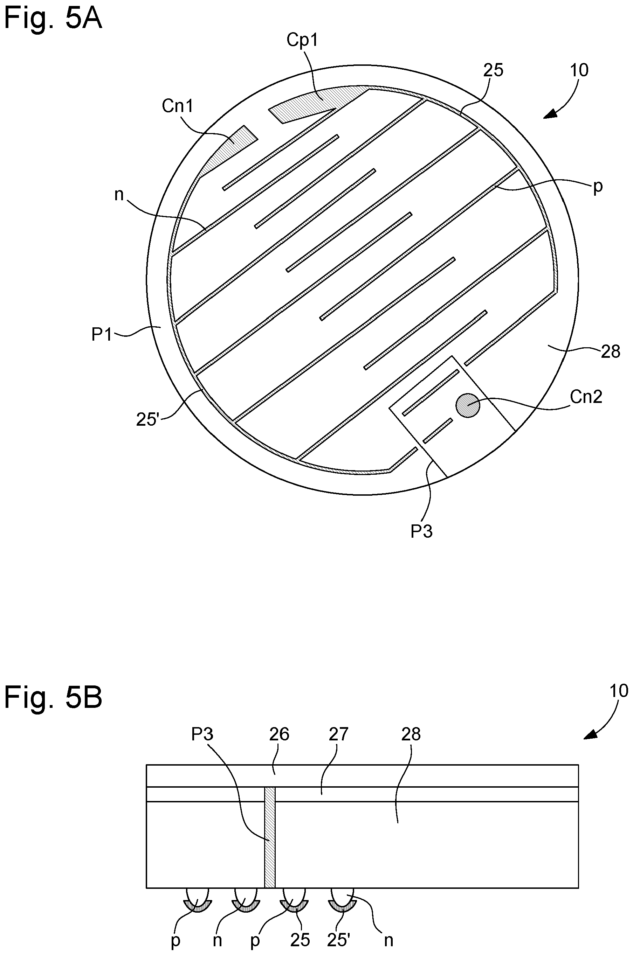

Les figures 5A et 5B représentent la seconde variante de réalisation de l'ensemble 10 à cellules photovoltaïques avec toute la connexion électrique par les contacts, réalisée au dos de l'ensemble à cellules photovoltaïques 10 sous le substrat 28 par l'intermédiaire d'au moins une couche conductrice 25, 25'. Dans cette seconde variante de réalisation, il s'agit de profiter des caractéristiques particulières des cellules silicium de type IBC (acronyme de *"interdigitated back contact*')*.* Dans cette réalisation, l'idée est de mettre en œuvre une cellule essentiellement mono-segment pour ce qui est du substrat monocristallin (plaquette), et de segmenter ou isoler seulement la structure arrière de la plaquette, par exemple diffusion et métallisation. Autrement dit, il s'agit d'affecter une petite zone de la cellule IBC à la mesure de la tension à vide Voc ou au courant court-circuit, au moyen d'au moins deux doigts ou peignes électriquement indépendants en dessous du substrat 28.

Comme on peut le remarquer à la figure 5B, l'ensemble 10 à cellules photovoltaïques est composé du haut vers le bas, d'au moins une couche de passivation 27 disposée directement sur le substrat 28, qui peut être composé de silicium cristallin. Cependant, il peut encore être ajouté sur la couche de passivation 27, une couche de nitrure de silicium SiN 26 comme couche antireflet ou d'oxyde de silicium SiO2. De plus sur la face opposée du substrat 28, il est réalisé au moins une zone de type p et une zone de type n, mais de préférence plusieurs zones de type p et de type n. Ces zones sont disposées en alternance espacées et parallèles l'une par rapport à l'autre. Ces zones peuvent être rectilignes ou avec une courbure, par exemple sous forme d'arc de cercle ou d'une autre forme adaptée. Ces zones sont recouvertes de la couche conductrice qui est structurée par la suite pour définir un premier peigne 25 et un second peigne 25'. Les dents du premier peigne 25 sont disposées au-dessus des zones de type p, alors que les dents du second peigne sont disposées au-dessus des zones de type n.

Il est à noter encore qu'il peut être monté ou fixé sur la couche antireflet 26, un support ou élément support, qui peut être en verre transparent pour la protéger de tout usure dans le temps. De plus, il peut encore être prévu de placer sur les peignes 25, 25' une couche de protection également pour les protéger de toute usure.

Il est à noter que les zones n et p peuvent être réalisées par diffusion ou dépôt de couches de chaque type respectif (par exemple Si amorphe dopé au Bore B ou au Phosphore P.

De préférence, un premier contact Cn1 négatif est disposé à proximité de la périphérie P1 du substrat 28 dans laquelle sont réalisées les cellules photovoltaïques. Un contact complémentaire Cp1 positif est réalisé également à proximité de la périphérie de la plaquette en léger regard par exemple du premier contact Cn1 négatif. Depuis chacun des contacts Cn1 et Cp1, il est réalisé au moins deux doigts conducteurs ou de préférence deux peignes conducteurs 25, 25' dont les dents sont prévues pour s'imbriquer alternativement et parallèlement l'une à côté de l'autre sur une même surface au dos du substrat 28. Dans le cas où le substrat 28 est sous forme circulaire, cela signifie que la ligne de maintien de chaque dent de chaque peigne 25, 25' décrit un arc de cercle en partant respectivement de chacun des contacts Cn1 et Cp1 et dans une direction opposée l'une de l'autre.

Le design interdigité peut être remplacé par d'autres designs. De plus, il n'est pas indispensable à la réalisation par exemple d'un double serpentin.

Le second ou autre contact Cn2 négatif est réalisé entre au moins deux doigts conducteurs ou entre les dents conductrices des peignes sans contact électrique avec l'un ou l'autre. Comme représenté à la figure 5A, le second contact Cn2 peut être disposé à la suite de la dernière dent du peigne 25'. De plus pour isoler cette dernière dent du reste du peigne 25', il est réalisé une coupure P3 de préférence des deux dernières dents 25, 25' du reste du peigne. On remarque bien cette coupure P3 permettant d'isoler la seconde cellule photovoltaïque de la première cellule photovoltaïque. Il est à noter toutefois que la petite zone prévue pour réaliser la seconde petite cellule photovoltaïque ou solaire de type IBC doit être bien définie. Cependant il est noté que cette seconde cellule photovoltaïque ou solaire est nécessairement plus petite que la première cellule photovoltaïque ou solaire qui est utilisée pour capter énergie lumineuse et la convertir en énergie électrique.

Cette seconde forme d'exécution ou seconde variante d'exécution, est plus compliquée à réaliser et à mettre en œuvre pour la mesure de la tension à vide. Cependant elle constitue une variante de réalisation à tenir compte.

L'invention offre l'avantage principal de permettre une mesure fréquente ou même permanente de la tension Voc, de sorte à pouvoir adapter rapidement le point de fonctionnement Vmpp. Cet avantage est d'autant plus important que les conditions d'éclairement changent rapidement et fréquemment, ce qui est typiquement le cas d'une montre portée par un utilisateur actif dont le cadran comprend la première cellule photovoltaïque et la seconde cellule photovoltaïque de mesure de la tension à vide.

Il est à noter que dans la première variante, la création de la mini cellule peut se faire très facilement dans le flux des étapes régulières de production, en n'allongeant que très peu la durée du procédé. De plus, esthétiquement la première variante n'est pas vraiment un problème, car l'ouverture créée est remplie de résine foncée, réduisant ainsi le contraste optique.

Comme pour la première variante de réalisation, il peut être inversé les bornes de connexion électrique fonction de l'agencement du circuit électronique lié à ces cellules photovoltaïques. Il peut être prévu une plage de contact commune à la masse plutôt qu'à la borne positive de l'alimentation. Ceci laisse une variation positive de tension d'adaptation au niveau de la première cellule photovoltaïque ou solaire générant une énergie électrique pour l'alimentation générale du circuit ou du module en tant que tel. Ceci permet aussi d'avoir une variation de tension à vide en adaptant sa tension pour déterminer le bon fonctionnement du module et de sa circuiterie.

Bien entendu, il peut être prévu plusieurs plages de contact Cn1, Cn2, Cp1 sur la plaquette pour une polarisation uniforme de chaque partie pour le bon fonctionnement du module 1. Dans le cas d'une réalisation des peignes conducteurs depuis la première plage de contact Cn1 et la plage complémentaire de contact Cp1, l'agencement des dents des deux peignes depuis la ligne de liaison de ces dents doit être assez régulier pour une bonne répartition ou polarisation de la plaquette. Il aurait pu aussi être imaginé d'avoir chaque peigne débutant depuis une plage de contact placée en périphérie de la plaquette ou dans une position presque centrale de la plaquette, mais toujours avec une alternance de dents de chaque peigne sur la surface de contact arrière de la plaquette. Il peut être aussi prévu d'avoir chaque plage de contact de peigne disposée en périphérie et à peu près à 180° l'une de l'autre. Cependant la forme d'exécution présentée à la figure 5B semble la plus plausible avec une bonne répartition de polarisation par l'agencement des dents des peignes conducteurs présentés. La longueur de chaque dent peut s'étendre plus que présentée sur la figure 5B.

Le principe décrit ci-dessus, visant à faciliter la mesure de la tension à vide Voc, peut aussi être mis à profit pour mesurer un autre paramètre important de la cellule photovoltaïque, à savoir son courant de court-circuit Isc (*short circuit*). La connaissance de ce courant permet également d'optimiser le point de fonctionnement, même si en pratique la tension à vide Voc est préférée. Cette tension à vide Voc est égale à In(I). Mais surtout le courant de court-circuit varie de manière quasi-linéaire avec l'intensité de l'éclairement, ce qui permet la réalisation aisée d'une fonction luxmètre. Une fois connu le comportement global du système de captage de lumière et de conversion en énergie électrique, l'intégration de la mesure du luxmètre permet d'estimer la quantité d'énergie récoltée, ce qui est une information utile pour l'optimisation de la gestion d'énergie et l'information à l'utilisateur final du produit.

Il est encore à noter à titre de rappel que la puissance maximale Pmpp correspond à un point de fonctionnement MPP, qui est caractérisé par une tension Vmpp et un courant Impp bien précis, et dépendant du niveau d'éclairement. La fonction de poursuite de de la puissance maximale Pmpp décrite précédemment, concerne la tension de la petite cellule, ce qui permet également d'approximer une fonction luxmètre, de deux manières distinctes indiquées ci-dessous :
- La tension Voc de la cellule photovoltaïque est un signal proportionnel au logarithme de l'irradiation. Il suffit de mesurer sa valeur pour en déduire un éclairement avec une table de correspondance (tension->lux),
- Alternativement si une petite résistance (<< Vmpp/Impp) est placée en parallèle de la petite cellule photovoltaïque, cette dernière donnera une tension proportionnelle à l'irradiation. Il suffit de mesurer sa valeur pour en déduire un éclairement avec une table de correspondance (tension->lux).

Il est à noter encore que la tension à vide peut être une mesure qui tient compte de l'intensité de l'éclairement de l'ensemble de cellules photovoltaïques.

La petite cellule photovoltaïque peut aussi être "shuntée" ou à dérivation par une faible résistance pour mesurer une tension électrique proportionnelle au courant en opération ou de court-circuit. Cela donne une variation linéaire de courant et de la tension.

Bien entendu, d'autres possibilités de réalisation de l'ensemble à cellules photovoltaïques peuvent être envisagées par l'homme du métier sans sortir du cadre de l'invention définie par les revendications.

## Revendications

1. Ensemble (10) à cellules photovoltaïques (2, 12) destiné à faire partie d'un module (1) à cellules photovoltaïques et à circuit électronique (3), **caractérisé en ce que** l'ensemble (10) comprend au moins une première cellule photovoltaïque (2) de grande taille, qui est agencée pour capter de l'énergie lumineuse à convertir en énergie électrique dans le module (1), et au moins une seconde cellule photovoltaïque (12) de petite taille et indépendante de la première cellule photovoltaïque (2), qui est agencée pour mesurer dans le module (1) une tension ou un courant pour optimiser le fonctionnement du module (1).

2. Ensemble (10) selon la revendication 1, **caractérisé en ce que** l'ensemble (10) comprend un substrat (22; 28) adapté pour la réalisation d'une ou plusieurs cellules photovoltaïques (2, 12).

3. Ensemble (10) selon la revendication 1, **caractérisé en ce que** l'ensemble (10) comprend au moins une couche conductrice (21, 23; 25, 25') sur une face de dessus d'un substrat (22; 28) ou d'un support, ou une face de dessous du substrat (22; 28) ou du support pour établir un contact électrique des cellules photovoltaïques (2, 12).

4. Ensemble (10) selon la revendication 3, **caractérisé en ce que** la couche conductrice est une première couche conductrice (21) disposée sur une face de dessus du substrat (22) ou du support, et **en ce que** l'ensemble (10) comprend une seconde couche conductrice (23) disposée sur la face de dessous du substrat (22) ou du support.

5. Ensemble (10) selon la revendication 4, **caractérisé en ce que** la première couche conductrice est une première couche conductrice transparente (21) pour l'ensemble, destinée à venir fixer le substrat sous une face d'un élément support de l'ensemble.

6. Ensemble (10) selon la revendication 1, **caractérisé en ce que** la première cellule photovoltaïque (2) est une cellule à couches minces disposée sur un support sous la forme d'un substrat.

7. Ensemble (10) selon la revendication 1, **caractérisé en ce que** le matériau de la première cellule photovoltaïque (2) est un silicium amorphe.

8. Ensemble (10) selon la revendication 5, **caractérisé en ce que** la seconde couche conductrice (23) est reliée à la première couche conductrice (21) par une ouverture périphérique de l'ensemble (10) réalisée dans le substrat (22) ou dans la première cellule photovoltaïque (2).

9. Ensemble (10) selon la revendication 8, **caractérisé en ce qu'**une isolation (P3) est réalisée pour définir la première cellule photovoltaïque (2), et **en ce qu'**une autre isolation (P13) est réalisée pour rendre indépendante la seconde cellule photovoltaïque (12) de la première cellule photovoltaïque (2) de manière à permettre à la seconde cellule photovoltaïque d'effectuer la mesure de la tension ou du courant dans le module (1).

10. Ensemble (10) selon l'une des revendications 8 et 9, **caractérisé en ce qu'**un contact positif (Cp1) est disposé sur la seconde couche conductrice (23) en périphérie destiné à permettre de polariser la première couche conductrice (21) à un même potentiel positif pour les deux cellules photovoltaïques, **en ce qu'**un contact négatif (Cn1) est disposé sur la grande cellule photovoltaïque (2) sur le substrat par l'intermédiaire de la seconde couche conductrice (23) isolée de la bordure (P2), et **en ce qu'**un autre contact négatif (Cn2) est disposé sur la petite cellule photovoltaïque (12) sur le substrat par l'intermédiaire de la seconde couche conductrice (23).

11. Ensemble (10) selon l'une des revendications précédentes, **caractérisé en ce que** des parties de l'ensemble (10), susceptibles d'être visibles, sont réalisées d'une même couleur que la première cellule (2) et/ou la seconde cellule (12) de manière à ne pas les distinguer à travers un verre de montre.

12. Ensemble (10) selon la revendication 1, **caractérisé en ce qu'**il comprend un substrat (28) au dos duquel sont réalisées en alternance et en parallèles des zones de type p et de type n, la couche conductrice étant disposée sur les zones de type p et de type n en étant structurée pour définir un premier peigne (25) et un second peigne (25'), les dents du premier peigne (25) étant disposées au-dessus des zones de type p, alors que les dents du second peigne (25') étant disposées au-dessus des zones de type n.

13. Ensemble (10) selon la revendication 12, **caractérisé en ce qu'**il est composé du haut vers le bas, d'au moins une couche de passivation (27) disposée directement sur une face supérieure du substrat (28), alors que la couche conductrice est disposée sur une face inférieure du substrat (28).

14. Ensemble (10) selon la revendication 12, **caractérisé en ce que** le substrat (28) est un substrat cristallin en silicium.

15. Ensemble (10) selon la revendication 13, **caractérisé en ce qu'**une couche antireflet (26) est disposée sur la couche de passivation (27).

16. Ensemble (10) selon la revendication 12, **caractérisé en ce que** les zones p et n et les dents des peignes sont rectilignes.

17. Ensemble (10) selon la revendication 12, **caractérisé en ce que** les zones p et n et les dents des peignes sont courbées ou arquées.

18. Ensemble (10) selon la revendication 12, **caractérisé en ce que** le premier peigne (25) est relié à un premier contact positif (Cp1), alors que le second peigne (25') est relié à un premier contact négatif (Cn1) en relation à la première cellule photovoltaïque (2), et **en ce que** le second contact négatif (Cn2) est pour être lié à une dernière dent du second peigne (25') ou deux dents des premier et second peignes isolées du reste des premier et second peignes (25; 25') par une coupure d'isolation (P3).

19. Ensemble (10) selon l'une des revendications précédentes, **caractérisé en ce que** la première cellule solaire ou photovoltaïque (2) prend la forme d'un cadran ou d'une lunette ou d'une glace d'une montre, ou d'une autre partie d'une montre.

20. Ensemble (10) selon l'une des revendications précédentes, **caractérisé en ce que** les cellules photovoltaïques ou solaires (2, 12) sont réalisées dans une ou des plaquettes de substrat, qui sont des plaquettes de silicium, ou sur un ou plusieurs supports d'un matériau en verre, ou en plastique, ou en métal avec une couche d'isolation, ou sur des couches cristallines.

21. Module (1) à cellules photovoltaïques et à circuit électronique (3) comprenant un ensemble (10) à cellules photovoltaïques (2, 12) selon l'une des revendications précédentes, **caractérisé en ce qu'**au moins une première cellule photovoltaïque (2) de grande taille est agencée pour capter de l'énergie lumineuse à convertir en énergie électrique, le module (1) comprenant également dans le circuit électronique (3), un contrôleur de commutation (5) et un adaptateur (4) d'optimisation de fonctionnement du module (1), et
**en ce qu'**au moins une seconde cellule photovoltaïque (12) de petite taille (P3, P13) et indépendante de la première cellule photovoltaïque (2), est agencée pour mesurer dans le module (1) une tension ou un courant pour un fonctionnement optimal du module.

22. Module (1) selon la revendication 21, **caractérisé en ce que** la tension mesurée est la tension à vide (Voc) de la seconde cellule photovoltaïque (12) qui est un signal proportionnel au logarithme de l'irradiation.

23. Module (1) selon la revendication 21, caractérisé en ce la seconde cellule photovoltaïque est à dérivation par une faible résistance pour mesurer une tension électrique proportionnelle au courant en opération ou de court-circuit.
